# EUROPÄISCHE PATENTSCHRIFT

(11) **EP 0 605 842 B1**
(45) Veröffentlichungstag und Bekanntmachung des Hinweises auf die Patenterteilung: **26.03.1997**
(21) Anmeldenummer: 93120653.6
(22) Anmeldetag: 22.12.1993
(51) Int. Cl.: H05K 5/00, B60R 16/02

(54) **Einrichtung für ein Fahrzeug**
Arrangement for a vehicle
Installation pour un véhicule

(30) Priorität: 24.12.1992 DE 4244064
(43) Veröffentlichungstag der Anmeldung: 13.07.1994
(73) Patentinhaber: Stribel GmbH, D-72636 Frickenhausen (DE)
(72) Erfinder: Stribel, Hans Peter, D-72622 Nürtingen (DE)

(56) Entgegenhaltungen:
- EP-A- 0 181 534
- DE-U- 6 928 695
- US-A- 5 101 322

## Beschreibung

Die Erfindung betrifft eine Einrichtung mit den Merkmalen des Oberbegriffs des Anspruchs 1.

Eine aus der DE 3439410 A1 bekannte Einrichtung dieser Art kann ein Kunststoffgehäuse aufweisen, in dem zur Bildung von Versorgungs- und Steuerstromkreisen aus Metallplatinen ausgestanzte Leiterstege in verschiedenen Ebenen übereinander angeordnet sind. Die Leiterstege können durch schenisolationen getrennt sein. Außerdem kann in einem oberen Raum des Gehäuses ein Mikrocomputer vorgesehen sein, dessen Bauteile, wie Mikroprozessor, Programmspeicher, Ein- und Ausgabeeinheit etc, auf einer Leiterplatte angeordnet sein können.

Die Aufgabe der Erfindung besteht darin, die an sich bewährte Einrichtung der vorbeschriebenen Art dahingehend weiterzubilden, daß mit einfachen Mitteln zuverlässige Steuer- und Versorgungsstromkreise, Werkzeugkosteneinsparungen und eine Reduzierung des Herstellungsaufwands erzielt werden.

Diese Aufgabe wird erfindungsgemäß durch die kennzeichnenden Merkmale des Anspruchs 1 gelöst.

Zweckmäßige Ausgestaltungen und Weiterbildungen der Erfindung sind durch die Merkmale der Unteransprüche gekennzeichnet.

Weitere Vorteile und wesentliche Einzelheiten der Erfindung sind der nachfolgenden Beschreibung und der Zeichnung zu entnehmen, die in schematischer Darstellung eine bevorzugte Ausführungsform als Beispiel zeigt. Es stellen dar:
- FIG. 1: eine erfindungsgemäße Einrichtung mit in verschiedenen Ebenen übereinander angeordneten gestanzten Leiterstegen, Zwischenisolationen und Leiterplatten in geschnittener Darstellung und
- FIG. 2: die Einrichtung gemäß FIG. 1 in einer Draufsicht.

Die in der Zeichnung dargestellte erfindungsgemäße Einrichtung 1 kann für den zentralen Anschluß elektrischer Bauteile in einem Kraftfahrzeug vorgesehen sein, wobei eine Vielzahl von elektrischen Versorgungs- und Steuerstromkreisen beispielsweise für Blinker, Lampen, Scheibenwischer, Magnetventile und dergleichen zentral zusammengefaßt werden können.

Die Einrichtung 1 kann ein lediglich gestrichelt dargestelltes, aus Kunststoff hergestelltes Gehäuse 2 aufweisen, das ein durch mehrere übereinander angeordnete Ebenen gebildetes Leiterpaket 3 umschließt. Das Leiterpaket 3 kann eine oder mehrere, beispielsweise drei Isolationsplatten 4 mit in Ausnehmungen oder Nuten gelagerten Leiterstegen 5 sowie eine oder mehrere, beispielsweise drei Leiterplatten 6 mit Leiterbahnen 7 aufweisen, die aufgedruckt oder aus aufkaschierten dünnen Metallfolien hergestellt sein können.

Das Leiterpaket 3 weist demnach verschiedene Stromkreise auf, die erfindungsgemäß derart ausgelegt sind, daß die dünnen und im Leitungsquerschnitt verhältnismäßig klein dimensionierten Leiterbahnen 7 der drei Leiterplatten 6 ausschließlich die verschiedenen Steuerstromkreise für die elektrischen Bauteile bilden, während die relativ dicken und bezüglich des Leitungsquerschnitts verhältnismäßig groß dimensionierten Leiterstege 5 in den Ebenen der unteren Isolationsplatten 4 ausschließlich als Versorgungsstromkreise für die elektrischen Bauteile ausgebildet sind. Dabei können die ausschließlich steuerstromkreisbildenden Leiterplatten 6 und die ausschließlich versorgungsstromkreisbildenden Leiterstege 5 mit den Isolationsplatten 4 in den verschiedenen parallelen Ebenen derart in ungefähr gleicher Flächenkonfiguration übereinander geschichtet sein, daß das Leiterpaket 3 in allen Ebenen in etwa gleich ist, so daß insgesamt eine kleinbauend kompakte Baueinheit gegeben ist, die bevorzugt als im wesentlichen rechtförmiges Mehrschichtenpaket ausgebildet sein kann.

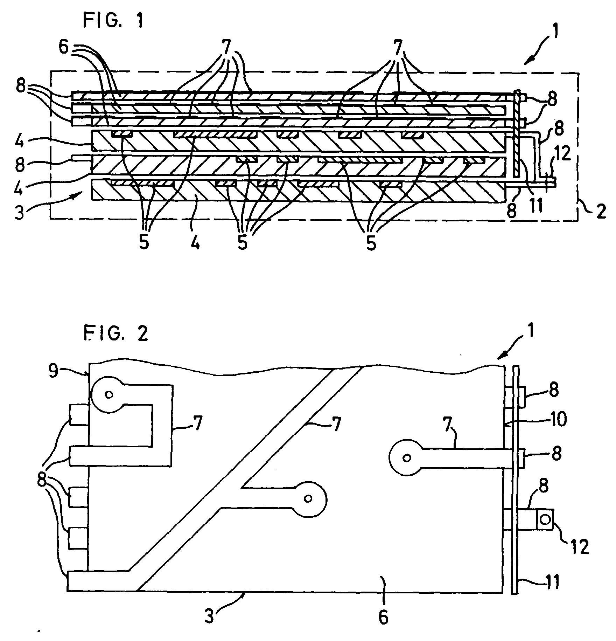

Um die Steuer- und/oder Versorgungsstromkreise der Einrichtung 1 wahlweise miteinander verbinden zu können, kann es zweckmäßig sein, an den Leiterstegen 5 und den Leiterplatten 6 mit den Leiterbahnen 7 Anschlußteile 8 auszubilden, die das Leiterpaket 3 an mindestens einem Rand 9,10, vorzugsweise an gegenüberliegenden Paketseiten überragen. Die Verbindung der Stromkreise kann dementsprechend vorteilhaft an einer oder mehreren Seiten des Leiterpakets 3 vorgesehen sein und bevorzugt als Leiterplattenteil 11 oder als Flachbandkabel ausgebildet sein, das bevorzugt eine Vielzahl von in einer Ebene parallel liegenden Einzelleitern aufweisen kann. Dabei kann die Verbindung der Stromkreise zweckmäßig so ausgeführt sein, daß beispielsweise der Leiterplattenteil 11 gemäß der zeichnerischen Darstellung in einem kleinen Abstand dicht neben dem Leiterpaket 3 quer zu dessen Schichtebene angeordnet ist. Die eigentliche elektrische Kontaktierung kann zum Beispiel vorzugsweise durch Löten oder als Steck- oder Nietverbindung 12 (FIG. 1) oder eine andere gleichwertige galvanische Verbindung ausgeführt sein. Wenn die Steuerstromkreise der Leiterplatten-Leiterbahnen 7 aus Metallfolienleitern gebildet sind, kann es auch günstig sein, letztere so auszubilden, daß sie beispielsweise am Rand 9,10 des Leiterpakets 3 in mindestens eine weitere Leiterplatten-Schichtebene um etwa 180 Grad umbiegbar sind. Dadurch können spezielle zusätzliche Stromkreisverbindungen eingespart werden.

Ein wesentlicher Vorteil der erfindungsgemäßen Einrichtung besteht darin, daß die Stromkreise gemäß ihren Funktionen klar getrennt sind, indem den aus Metallblechen ausgestanzten Leiterstegen 5 allein die Funktion der Versorgungsstromkreise zukommt, während die Funktion der davon klar abgegrenzten Steuerstromkreise allein durch die Leiterbahnen 7 der Leiterplatten 6 erfüllt wird. Dadurch wird eine kostengünstige Herstellung und hohe Funktionssicherheit erreicht. Die Steuerstromkreise können in bekannter Printtechnik-Verfahrensweise einfacher und vielfältiger und technisch hochwertiger ausgeführt werden als dies mit aus Blechen ausgestanzten Leiterzügen möglich ist. Die Leiterplatten-Steuerstromkreise weisen aufgrund der zuverlässigen und problemlosen Herstellmöglichkeiten gegenüber gestanzten Leiterstegen, die zum Beispiel verbogen sein können, praktisch keine Fehlerquote auf. Außerdem können die Steuerstromkreise auf den Leiterplatten bereits vor dem Zusammenbau des Leiterpakets einfach und sicher geprüft werden, so daß etwaige Fehler rechtzeitig erkannt und behoben werden können. Die gestanzten Leiterstege 5 der Versorgungstromkreise können nach dem Zusammenbau des Leiterpakets 3 auf Funktionstüchtigkeit geprüft werden.

Außerdem wird eine weitere Reduzierung der Herstellkosten dadurch erzielt, daß für die Steuerstromkreise der erfindungsgemäßen Einrichtung 1 keine besonderen Stanzwerkzeuge erforderlich sind, so daß insgesamt eine technisch sehr zuverlässige und dennoch äußerst kostengünstige Einrichtung 1 gegeben ist.

Um beispielsweise eine zweckmäßige und möglichst unkomplizierte Verbindung der Stromkreise zu erzielen, kann es zudem günstig sein, die Steuer- und Versorgungsstromkreise je nach Erfordernis in verschiedenen Ebenen einander zuzuordnen. Die Leiterplatten 6 und die Leiterstege 5 mit den Zwischenisolationen 4 können somit nach Bedarf in wahlweise regel- oder unregelmäßiger Folge zueinander übereinandergeschichtet werden.

## Patentansprüche

1. Einrichtung für ein Fahrzeug, insbesondere Kraftfahrzeug, für den zentralen Anschluß elektrischer Bauteile mit in einem Gehäuse (2) vorgesehenen Versorgungs- und Steuerstromkreisen, mindestens einer Leiterplatte (6), in verschiedenen Ebenen angeordneten, aus Metallplatinen ausgestanzten Leiterstegen (5) und Zwischenisolationen (4), dadurch gekennzeichnet, daß die Versorgungs- und Steuerstromkreise derart verschieden ausgebildet und voneinander getrennt angeordnet sind, daß die Versorgungsstromkreise ausschließlich aus den ausgestanzten relativ dicken und bezüglich des Leitungsquerschnitts verhältnismäßig groß dimensionierten Leiterstegen (5) und die Steuerstromkreise ausschließlich aus relativ dünnen und im Leitungsquerschnitt verhältnismäßig klein dimensionierten Leiterbahnen (7) der Leiterplatten (6) gebildet sind, daß die Leiterstege (5), die Zwischenisolationen (4) und die Leiterplatten (6) in verschiedenen parallelen Ebenen in wahlweise regelmäßiger oder unregelmäßiger Folge zueinander derart in ungefähr gleicher Flächenkonfiguration übereinandergeschichtet sind, daß ein in allen Ebenen etwa gleiches Leiterpaket (3) gebildet ist, und daß die Steuerstromkreise der Leiterplatten (6) vor und die Versorgungsstromkreise der Leiterstege (5) nach dem Zusammenbau des Leiterpaketes (3) funktionsprüfbar sind.

2. Einrichtung nach vorstehendem Anspruch, dadurch gekennzeichnet, daß die Steuerstromkreise der Leiterplatten (6) aus gedruckten Leiterbahnen (7) oder aus dünnen Metallfolien gebildet sind.

3. Einrichtung nach einem oder mehreren der vorstehenden Ansprüche, dadurch gekennzeichnet, daß die Steuerstromkreise und/oder die Versorgungsstromkreise wahlweise miteinander verbindbar sind.

4. Einrichtung nach einem oder mehreren der vorstehenden Ansprüche, dadurch gekennzeichnet, daß die Verbindung der Stromkreise an einer oder mehreren Seiten des Leiterpakets (3) quer zur Schichtebene vorgesehen ist.

5. Einrichtung nach einem oder mehreren der vorstehenden Ansprüche, dadurch gekennzeichnet, daß die Verbindung der Stromkreise steck-, niet- oder lötbar ist oder in einer anderen technisch gleichwertigen galvanischen Kontaktierung ausgeführt ist.

6. Einrichtung nach einem oder mehreren der vorstehenden Ansprüche, dadurch gekennzeichnet, daß die Verbindung der Stromkreise als Leiterplattenteil (11), Flachbandkabel oder Metallfolienleiter ausgebildet ist.

7. Einrichtung nach einem oder mehreren der vorstehenden Ansprüche, dadurch gekennzeichnet, daß die Versorgungs- und Steuerstromkreise am Rand (9,10) des Leiterpakets (3) überragende Anschlußteile (8) für die Verbindung aufweisen.

8. Einrichtung nach einem oder mehreren der vorstehenden Ansprüche, dadurch gekennzeichnet, daß die Metallfolienleiter der Steuerstromkreise am Rand (9,10) des Leiterpakets (3) in mindestens eine weitere Schichtebene umbiegbar sind.

## Claims

1. Installation for a vehicle, especially an automobile, for the central connection of electrical components, comprising supply and control circuits, at least one printed circuit board (6), conductor webs (5) stamped out from metal plates and intermediate insulations (4) all disposed in different planes in a housing (2), characterized in that the supply and control circuits are constructed differently and are disposed separated from one another in such a manner that the supply circuits are formed exclusively of the stamped-out, relatively thick conductor webs (5), of comparatively large dimensions with regard to the conducting cross-section, and the control circuits are formed exclusively of relatively thin conductor paths (7), of comparatively small dimensions in the conducting cross-section, of the printed circuit boards (6), that the conductor webs (5), the intermediate insulations (4) and the printed circuit boards (6) are arranged in layers one above another in an approximately equal area configuration in different parallel planes in an optionally regular or irregular sequence to one another in such a way that an approximately equal conductor packet (3) is formed in all planes, and that the control circuits of the printed circuit boards (6) can be functionally tested before and the supply circuits of the conductor webs (5) after the conductor packet (3) is assembled.

2. Installation according to the preceding claim, characterized in that the control circuits of the printed circuit boards (6) are formed of printed conductor paths (7) or of thin metal foils.

3. Installation according to one or more of the preceding claims, characterized in that the control circuits and/or the supply circuits can be connected as desired with one another.

4. Installation according to one or more of the preceding claims, characterized in that the connection of the circuits is provided at one or more sides of the conductor packet (3) transversely to the layer plane.

5. Installation according to one or more of the preceding claims, characterized in that the connection of the control circuits can be plugged-in riveted or soldered or carried out in another technically equivalent galvanic contacting method.

6. Installation according to one or more of the preceding claims, characterized in that the connection of the circuits is formed as a circuit board part (11), flat strip cable or metal foil conductor.

7. Installation according to one or more of the preceding claims, characterized in that the supply and control circuits have connection parts (8) projecting at the edge (9, 10) of the conductor packet (3) for the connection.

8. Installation according to one or more of the preceding claims, characterized in that the metal foil conductors of the control circuits can be bent over into at least one other layer plane at the edge (9, 10) of the conductor packet (3).

## Revendications

1. Installation destinée à un véhicule, en particulier un véhicule automobile, pour assurer le raccordement centralisé de composants électriques comportant à l'intérieur d'un boîtier (2) des circuits d'alimentation et de commande, au moins un circuit imprimé (6) des barrettes conductrices (5) découpées dans des feuilles métalliques et disposées dans des plans différents ainsi que des isolants intermédiaires (4), caractérisée en ce que :
- les circuits d'alimentation et de commande sont constitués différemment et séparés les uns des autres ;
- les circuits d'alimentation sont constitués exclusivement de barrettes découpées (5) qui sont relativement épaisses et ont une section conductrice relativement grande ;
- les circuits de commande sont constitués exclusivement des pistes conductrices (7) qui appartiennent aux circuits imprimés (6), sont relativement minces et une section conductrice relativement petite ;
- les barrettes conductrices (5), les isolants intermédiaires (4) et les circuits imprimés (6) sont superposés selon différents plans se succédant régulièrement ou non et présentant en surface des configurations sensiblement identiques ;
- l'ensemble forme un bloc imprimé (3) ayant tous ses plans sensiblement égaux ;
- le fonctionnement des circuits de commande des circuits imprimés (6) peut être contrôlé avant l'assemblage du bloc (3), tandis que celui des circuits d'alimentation peut l'être après.

2. Installation selon la revendication 1, caractérisée en ce que les circuits de commande des circuits imprimés (6) sont des pistes imprimées (7) ou de minces feuilles métalliques.

3. Installation selon une ou plusieurs des revendications précédentes, caractérisée en ce que les circuits de commande et/ou les circuits d'alimentation peuvent à volonté être reliés entre eux.

4. Installation selon une ou plusieurs des revendications précédentes, caractérisée en ce que la liaison des circuits électriques est prévue sur un ou plusieurs côtés du bloc (3), perpendiculairement aux plans des couches.

5. Installation selon une ou plusieurs des revendications précédentes, caractérisée en ce que la liaison des circuits d'alimentation peut être réalisée par des broches, des rivets ou des soudures ou par tout autre moyen de contact électrique galvanique.

6. Installation selon une ou plusieurs des revendications précédentes, caractérisée en ce que la liaison des circuits électriques est assurée par un élément de circuit imprimé (11), un câble plat ou une feuille métallique conductrice.

7. Installation selon une ou plusieurs des revendications précédentes, caractérisée en ce que les circuits de commande et d'alimentation présentent des raccords (8) de liaison, dépassant les bords (9, 10) du bloc imprimé (3).

8. Installation selon une ou plusieurs des revendications précédentes, caractérisée en ce que les feuilles métalliques conductrices des circuits de commande situées le long des bords (9, 10) du bloc imprimé (3) peuvent être repliées dans au moins un autre plan de couche.
